(19) Europäisches Patentamt
European Patent Office
Office européen des brevets

(11) Veröffentlichungsnummer: **0 335 836**
**A2**

(12) **EUROPÄISCHE PATENTANMELDUNG**

(21) Anmeldenummer: **89810227.2**

(51) Int. Cl.[4]: **G 03 F 7/08**

(22) Anmeldetag: **22.03.89**

(30) Priorität: **31.03.88 DE 3811040**

(43) Veröffentlichungstag der Anmeldung:
**04.10.89 Patentblatt 89/40**

(84) Benannte Vertragsstaaten:
**AT BE CH DE FR GB IT LI NL SE**

(71) Anmelder: **CIBA-GEIGY AG**
**Klybeckstrasse 141**
**CH-4002 Basel (CH)**

(72) Erfinder: **Schulz, Reinhard, Dr.**
**Im Trappengrund 44**
**D-6107 Reinheim (DE)**

**Münzel, Horst, Dr.**
**Rüdesheimer Strasse 20**
**D-6100 Darmstadt (DE)**

(54) **Im nahen UV hochauflösende Positiv-Fotoresists.**

(57) Mit Positiv-Fotoresists, enthaltend in einem organischen Lösungsmittel im wesentlichen mindestens je

(a) ein alkalilösliches Harz

(b) einen 1,2-Naphthochinondiazid-5-sulfonylester eines Trihydroxybenzol-Isomeren

(c) eine aromatische Hydroxyverbindung sowie gegebenenfalls weitere übliche Zusatzstoffe, in denen durch Komponente (b) für die fotobleichbare Absorption ein Absorptionskoeffizient von mindestens 0,5 $\mu m^{-1}$ resultiert und Komponente (c) in einer Konzentration von 15-30 Gew.%, bezogen auf den Gesamtfeststoffgehalt, enthalten ist, lassen sich im nahen UV hoch aufgelöste Strukturen hoher Kantenschärfe und Kantensteilheit erhalten.

EP 0 335 836 A2

## Beschreibung

### Im nahen UV hochauflösende Positiv-Fotoresists

Die Erfindung betrifft im nahen UV hochauflösende Positiv-Fotoresists.

Die Herstellung von Halbleiterbauelementen und integrierten Schaltungen in der Mikroelektronik erfolgt praktisch ausschließlich unter Anwendung photolithographischer Strukturierungsprozesse. Zur Herstellung von bestimmte Schaltungsstrukturen aufweisenden Mikrochips wird das Halbleitersubstratmaterial, im allgemeinen sind das Siliziumscheiben, mit Fotolack beschichtet und durch bildmäßiges Belichten und anschließendes Entwickeln werden hierauf Fotoresist-Reliefstrukturen erzeugt. Diese dienen als Maske für die eigentlichen Strukturierungsprozesse am Halbleitersubstrat wie Ätzen, Dotieren, Beschichten mit Metallen, anderen Halbleiter- oder auch Isolatormaterialien. Nach diesen Prozessen werden die Fotoresist-Masken je nach Notwendigkeit wieder entfernt. Durch eine Vielzahl derartiger Prozeßzyklen entstehen auf dem Substrat die Schaltungsstrukturen der Mikrochips.

Es werden grundsätzlich zwei verschiedene Typen von Fotoresists unterschieden: Bei positiv arbeitenden Fotoresists werden die belichteten Bereiche durch einen Entwicklungsprozeß abgelöst, während die unbelichteten Bereiche als Schicht auf dem Substrat verbleiben. Bei negativ arbeitenden Fotoresists verbleiben umgekehrt die bestrahlten Schichtbereiche als Reliefstruktur. Positiv-Fotoresists besitzen von ihrer Natur her eine höhere Bildauflösung und werden deshalb überwiegend bei der Herstellung von VLSI-Schaltungen eingesetzt.

Positiv-Fotoresists üblicher Art enthalten in einem organischen Lösungsmittel im wesentlichen mindestens je ein in wäßrigen Alkalien lösliches Harz und eine fotoempfindliche Chinondiazidverbindung, die die Alkalilöslichkeit des Harzes reduziert. Durch Strahlungseinwirkung auf mit derartigen Zusammensetzungen erzeugte Fotoresistschichten wird die Alkalilöslichkeit in den belichteten Bereichen durch fotoinduzierte strukturelle Umwandlung der Chinondiazidverbindung in ein Carbonsäurederivat erhöht, sodaß nach Entwicklung in wäßrig-alkalischen Entwicklungsbädern positive Fotoresist-Reliefstrukturen erhalten werden.

Als fotoempfindliche Chinondiazidverbindungen sind bevorzugt Veresterungsprodukte der 1,2-Naphthochinon-2-diazid5-sulfonsäure oder 1,2-Naphthochinon-2-diazid-4-sulfonsäure mit niedermolekularen aromatischen Hydroxyverbindungen, insbesondere Hydroxybenzophenonen wie 2,3,4-Trihydroxybenzophenon und 2,3,4,4′-Tetrahydroxybenzophenon sowie Trihydroxybenzolen im Gebrauch. Diese Naphthochinondiazidverbindungen verfügen über eine breite Absorption im nahen bis mittleren UV-Wellenlängenbereich zwischen ca. 300 und 450 nm. In diesem Wellenlängenbereich liegen kräftige Emissionslinien der üblicherweise in den Projektionsgeräten eingesetzten Quecksilberlampen, wie etwa die Linien bei 313 nm, 334 nm, 365 nm, 405 nm und 436 nm.

Weiterhin können Positiv-Fotoresists üblicherweise noch modifizierende Zusätze enthalten, insbesondere Additive zur Steigerung der Empfindlichkeit und zur Steuerung der Entwicklungsrate sowie strahlungsabsorbierende Agenzien und Farbstoffe zur Dämpfung von auflösungsvermindernden Reflexions- und Streueffekten.

Die für die technische Anwendbarkeit wesentlichen Merkmale eines Fotoresist sind Strahlungsempfindlichkeit, Bildauflösung und Kontrast.

Eine hohe Empfindlichkeit ist wichtig, um in den produktionstechnischen Prozeßzyklen kurze Bestrahlungszeiten zu gewährleisten, auch etwa, wenn gerätetechnisch bedingt nur Strahlung geringerer Intensität, beispielsweise bei monochromatischer Belichtung, auf den Resist einwirken kann.

Die Bildauflösung charakterisiert, bis zu welchen Dimensionen kleinste Bildstrukturen der Vorlage, wie etwa Linien und Zwischenräume, klar getrennt und maßgetreu durch den Fotoresist in Form von Stegen und Gräben wiedergegeben werden können. Die Herstellung von VLSI-Schaltungen erfordert die Wiedergabe von Strukturdetails in der Größenordnung von 1 µm und weniger.

Der Kontrast charakterisiert die Kantensteilheit und Kantenschärfe der nach der Entwicklung erhaltenen Fotoresist-Reliefstrukturen. Diese sollten möglichst scharfkantig sein und im Idealfall 90°-Flanken aufweisen.

Die bei der Erzeugung von Fotoresist-Strukturen erzielbare Auflösung ist in erster Linie abhängig von den materialspezifischen Eigenschaften des Fotoresist, wie insbesondere Absorption und Quantenausbeute der reaktionsauslösenden Strahlung sowie Entwicklungsverhalten; sie findet ihre untere Grenze in der optischen Qualität der Belichtungsgeräte und theoretisch durch die Wellenlänge der verwendeten Strahlung. Optiken, die für höchste Ansprüche bei monochromatischer Belichtung ausgelegt sind, müssen eine hohe numerische Apertur aufweisen. Mit steigender numerischer Apertur sinkt jedoch die Schärfentiefe und damit der für eine Anwendung unter Produktionsbedingungen erforderliche Fokussierungsspielraum erheblich. Die Erzielung höherer Auflösungen durch die Anwendung von Strahlung kleinerer Wellenlänge, wie etwa Tief-UV oder Röntgenstrahlung ist mit den gängigen Positiv-Fotoresists wegen ihrer fotochemischen Eigenschaften und mit den üblichen, im nahen UV mit Strahlung des Quecksilber-Spektrums arbeitenden Belichtungsgeräten nicht möglich. Einer Auflösungssteigerung mit optischen Maßnahmen sind somit praktische Grenzen gesetzt.

Die derzeit üblichen Positiv-Fotoresists auf Basis von alkalilöslichem Harz und Naphthochinondiazid-Verbindungen ermöglichen bei Belichtung im nahen UV mit Objektiven einer numerischen Apertur von 0,3-0,4 eine Auflösung bis herab zu 0,8-0,9 µm. Bei der Forderung nach immer höherer Integrationsdichte auf Mikrochips besteht daher ein großer Bedarf an höher auflösenden Positiv-Fotoresists, die im nahen UV strukturierbar sind und insbesondere in den in der Massenproduktion in großem Umfang eingesetzten

Wafer-Steppern, die überwiegend monochromatisch mit der Strahlung der Quecksilber-G-Linie (436 nm) arbeiten, verarbeitet werden können. Für den Submikrometerbereich gilt hierbei eine Auflösungsverbesserung um 0,1-0,3 µm gegenüber dem Stand der Technik als erheblich. Es bestand daher die Aufgabe, Positiv-Fotoresists nach dem Stand der Technik dahingehend zu verbessern, daß sie im nahen UV eine deutlich gesteigerte Auflösung zeigen und auch im Bereich höchster Auflösung Strukturen hoher Kantenschärfe und Kantensteilheit liefern.

Überraschend wurde nun gefunden, daß Positiv-Fotoresists, enthaltend in einem organischen Lösungsmittel im wesentlichen mindestens je

(a) ein alkalilösliches Harz,

(b) einen 1,2-Naphthochinon-5-sulfonylester eines Trihydroxybenzol-Isomeren,

(c) eine aromatische Hydroxyverbindung sowie gegebenenfalls weitere übliche Zusatzstoffe, bei Belichtung mit Strahlung im nahen UV eine erheblich verbesserte Auflösung zeigen, wenn in ihnen durch Komponente (b) für die fotobleichbare Absorption ein Absorptionskoeffizient von mindestens 0,5 $\mu m^{-1}$ resultiert und Komponente (c) in einer Konzentration von 15-30 Gew.%, bezogen auf den Gesamtfeststoffgehalt, enthalten ist.

Mit derartig zusammengesetzten Positiv-Fotoresists können bei G-Linien-Belichtung mit einer numerischen Apertur von 0,35 Strukturdetails bis herab zu wenigstens 0,6 µm scharfkantig und mit praktisch 90°-Flanken problemlos wiedergegeben werden.

Zwar sind Positiv-Fotoresists, die die angegebenen Komponenten (a), (b) und (c) enthalten, bereits aus der deutschen Patentanmeldung P 37 24 791 bekannt; die dort beschriebenen Positiv-Fotoresists waren jedoch quantitativ anders zusammengesetzt und zeigten dementsprechend auch nicht die gewünscht hohe Auflösung. Auch mit hinsichtlich Absorptionskoeffizient und Gehalt an aromatischer Hydroxyverbindung ähnlich zusammengesetzte Fotoresists, die aber Naphthochinondiazidsulfonylester von Hydroxybenzophenonen enthalten, wie etwa im US-Patent 4,626,492 beschrieben, läßt sich ebenfalls nicht die gewünscht hohe Auflösung erzielen.

Gegenstand der Erfindung sind somit Positiv-Fotoresists, enthaltend in einem organischen Lösungsmittel im wesentlichen mindestens je

(a) ein alkalilösliches Harz

(b) einen 1,2-Naphthochinondiazid-5-sulfonylester eines Trihydroxybenzol-Isomeren

(c) eine aromatische Hydroxyverbindung sowie gegebenenfalls weitere übliche Zusatzstoffe, die dadurch charakterisiert sind, daß durch Komponente (b) für die fotobleichbare Absorption ein Absorptionskoeffizient von mindestens 0,5 $\mu m^{-1}$ resultiert und Komponente (c) in einer Konzentration von 15-30 Gew.%, bezogen auf den Gesamtfeststoffgehalt, enthalten ist.

Gegenstand der Erfindung sind insbesondere derartige Positiv-Fotoresists, bei denen die Komponente (b) der 1,2-Naphthochinondiazid-5-sulfonyltrisester von 1,3,5-Trihydroxybenzol und die Komponente (c) 2,3,4-Trihydroxybenzophenon ist.

Gegenstand der Erfindung ist weiterhin die Verwendung derartiger Positiv-Fotoresists als im nahen UV hochauflösende Fotoresists.

Gegenstand der Erfindung ist darüber hinaus ein Verfahren zur Herstellung von Fotoresistreliefstrukturen mit einer Auflösung bis herab zu wenigstens 0,6 µm durch Beschichten eines Halbleitersubstrates mit einem Positiv-Fotoresist, bildmäßiges Belichten mit Strahlung aus dem nahen UV-Wellenlängenbereich und Entwickeln mit einem wäßrig alkalischen Entwickler, wobei ein wie vorstehend charakterisierter Positiv-Fotoresist verwendet wird.

Ein Parameter, mit dem sich die Abbildungseigenschaften eines Positiv-Fotoresist sehr gut charakterisieren lassen, ist, wie dem Fachmann geläufig, der Absorptionskoeffizient der fotobleichbaren Absorption, A-Wert, für eine vorgegebenen Bestrahlungswellenlänge (siehe hierzu z.B.: F.H. Dill, W.P. Hornberger, P.S. Hauge, J.M. Shaw, IEE Trans. Electr. Dev. ED-22, 445 (1975)). Der A-Wert enthält die stoffspezifische molare Extinktion und die Konzentration der fotoreaktiven Komponente des Fotoresist. Während der Bestrahlung des Fotoresist nimmt aufgrund der fotoinduzierten Umwandlung diese Absorption ab. Daneben spielt auch der Absorptionskoeffizient der nicht fotobleichbaren Absorption, B-Wert, eine Rolle. Dieser Beitrag zur Gesamtabsorption bei der Bestrahlungswellenlänge stammt vom Fotolyseprodukt der fotoreaktiven Komponente(n) und aus den anderen, nicht fotoreaktiven Bestandteilen des Fotoresist, z.B. zugesetzten Farbstoffen.

Es ist bekannt, daß sich mit Positiv-Fotoresists bessere Ergebnisse hinsichtlich Kantenschärfe und Flankensteilheit erzielen lassen, sowie daß sie bezüglich des Fokussierungsspielraumes weniger kritisch sind, wenn sie einen hohen A-Wert aufweisen. Fotoreaktive Komponenten mit hohem Anteil an strahlungsempfindlichen Gruppen im Molekül, z.B. Naphthochinondiazidsulfonyl-Tris- und -Tetraester von aromatischen Hydroxyverbindungen haben naturgemäß eine hohe molare Extinktion für die fotobleichbare Absorption und bedürfen daher geringerer Gesamtkonzentration im Fotoresist zur Einstellung eines bestimmten A-Wertes als beispielsweise die Mono- oder Bisester. Durch eine hohe lokale Konzentration an fotoreaktiver Komponente sollte daher mit einer theoretisch einhergehenden höheren differentiellen Löslichkeit auch eine höhere Strukturauflösung zu realisieren sein. Es zeigte sich jedoch, daß bei Vorliegen hoher Konzentrationen üblicher Naphthochinon diazidsulfonylester von Tri- oder Tetrahydroxybenzophenonen, die normalerweise keine einheitlichen Produkte, sondern Gemische der Voll- und Teilester sind, aufgrund erhöhter Entwicklerlöslichkeit dieser Resists keine Strukturen der gewünschten Auflösung mit hoher Kantenschärfe und Kantensteilheit

zu erhalten sind. Fotoresists mit den als einheitliche Produkte erhältlichen Naphthochinondiazidsulfonyl-Trisestern der Trihydroxybenzole in hoher Konzentration erweisen sich andererseits praktisch als nicht mehr entwickelbar. Erfindungsgemäß gelang es erst durch den Zusatz von Entwicklungsrate steigernden aromatischen Hydroxyverbindungen in einer Konzentration von 15-30 Gew.%, bezogen auf den Gesamtfeststoffgehalt des Fotoresist, und bei Einstellung eines A-Wertes von mindestens 0,5 $\mu m^{-1}$ durch Naphthochinondiazidsulfonylester von Trihydroxybenzol-Isomeren, Strukturen mit einer Auflösung bis herab zu wenigstens 0,6 µm mit hoher Kantenschärfe und Kantensteilheit zu erhalten.

Die erfindungsgemäßen Positiv-Fotoresists enthalten in einem organischen Lösungsmittel als Harzkomponente ein alkalilösliches Harz, als fotoempfindliche Komponente einen 1,2-Naphthochinondiazid-5-sulfonylester eines Trihydroxybenzol-Isomeren in einem Gehalt, daß für die fotobleichbare Absorption ein Absorptionskoeffizient von mindestens 0,5 $\mu m^{-1}$ resultiert, sowie eine die Entwicklungsrate steigernde aromatische Hydroxyverbindung in einer Konzentration von 15-30 Gew.%, bezogen auf den Gesamtfeststoffgehalt. Gegebenenfalls können sie noch weitere übliche Zusatzstoffe enthalten, mit denen gegebenenfalls die Eigenschaften des Fotoresist auf spezifische Anforderungen der Einsatzzwecke eingestellt werden können.

Als Harzkomponente sind im Prinzip alle in der Fotoresist-Technik üblichen alkalilöslichen Harze geeignet, wie z.B. Novolak-Harze, die durch Kondensation von Phenol bzw. phenolischen Verbindungen mit Aldehyden erhalten werden. Bevorzugt sind Kresol-Formaldehyd-Harze, zu deren Herstellung o-, m-, p-Kresol oder Mischungen dieser Isomeren in beliebigen oder vorbestimmten Verhältnissen eingesetzt werden. Die Herstellung solcher Harze und ihr Einsatz in Positiv-Fotoresits ist z.B. in US-Patent 4,377,631 beschrieben. Außerdem kommen auch andere alkalilösliche Harze in Frage, wie sie vielfach in Positiv-Fotoresists verwendet werden. Dazu gehören etwa Poly-Vinylphenole und Poly-Glutarimide, Copolymere aus Styrol und α-Methylstyrol mit Maleinimid sowie Copolymere aus N-(p-Hydroxyphenyl)-Maleinimid und Olefinen. Weiterhin können auch silylierte Derivate alkalilöslicher Polymere verwendet werden, die eine höhere Plasmaätzbeständigkeit aufweisen. In den erfindungsgemäßen Positiv-Fotoresists bildet die Harzkomponente einen Anteil von etwa 40-70 Gew.%, bezogen auf den Gesamtfeststoffgehalt.

Als fotoempfindliche Komponenten werden in den erfindungsgemäßen Positiv-Fotoresists 1,2-Naphthochinondiazid-5-sulfonylester von Trihydroxybenzol-Isomeren eingesetzt. Es können dies sein die Trisester von 1,2,3-, 1,2,4- und 1,3,5-Trihydroxybenzol. Diese Verbindungen sind bekannt und können in einfacher Weise durch Veresterung der entsprechenden Trihydroxybenzol-Isomeren mit 1,2-Naphthochinondiazid-5-sulfonylchlorid als reine Vollester erhalten werden. Die isomeren Formen dieser Trisester werden normalerweise rein eingesetzt, können aber auch im Gemisch miteinander verwendet werden. Ihr Einsatz in den erfindungsgemäßen Positiv-Fotoresists erfolgt in einem Anteil, so daß für die fotobleichbare Absorption ein Absorptionkoeffizient von mindestens 0,5 $\mu m^{-1}$ resultiert. Vorzugs weise liegt der einzustellende A-Wert im Bereich zwischen 0,55 und 0,75 $\mu m^{-1}$ bei einer Bestrahlungswellenlänge von 436 nm. Dies ist in Abhängigkeit der geringfügig variierenden molaren Extinktionen dieser Isomeren àb einem Gehalt von etwa 17 Gew.%, bezogen auf den Gesamtfeststoffgehalt, der Fall. Bevorzugt als strahlungsempfindliche Komponente ist der 1,2-Naphthochinondiazid-5-sulfonyltrisester von 1,3,5-Trihydroxybenzol. Dieser wird vorzugsweise in einer Konzentration von 17-30 Gew.% bezogen auf den Gesamtfeststoffgehalt eingesetzt.

Die erfindungsgemäßen Positiv-Fotoresists enthalten weiterhin zur Steigerung der Entwicklungsrate eine aromatische Hydroxyverbindung in einem Anteil von 15-30 Gew.%, bezogen auf den Gesamtfeststoffgehalt.

Es sind dies vornehmlich Verbindungen der Formel I

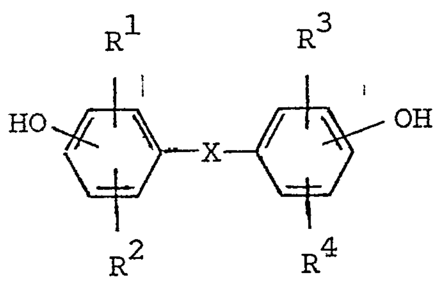

(I)

worin

X eine Einfachbindung, -O-, -S-, $SO_2$, CO oder $CR_5R_6$,

$R^1$, $R^2$, $R^3$, $R^4$ jeweils H, Halogen, $C_{1-4}$-Alkyl, $C_{1-4}$-Alkoxy oder OH,

$R^5$, $R^6$ jeweils H, $C_{1-4}$-Alkyl oder $C_{1-14}$-Perfluoralkyl

bedeuten.

Die Verbindungen der Formel I sind Bisphenyl-Verbindungen, in denen jeder Phenylring mindestens eine Hydroxygruppe trägt und in denen die beiden Phenylringe über eine Brücke X, die eine Einfachbindung, eine Sauerstoff-, Schwefel-, Sulfon-, Carbonyl- oder eine gegebenenfalls mit $C_{1-4}$-Alkyl oder $C_{1-4}$-Perfluoralkyl substituierte Methylengruppe darstellen kann, verknüpft sind. Die Reste $R^1$, $R^2$, $R^3$ und $R^4$ können, sofern sie nicht Wasserstoff bedeuten, Halogen wie Fluor, Chlor, Brom, $C_{1-4}$-Alkyl wie Methyl, Ethyl, n- oder i-Propyl, n-, i-, t-Butyl, $C_{1-4}$-Alkoxy wie Methoxy, Ethoxy, n-, i-Propoxy, n-, i-, t-Butoxy sowie OH sein.

Vorzugsweise enthalten die Verbindungen der Formel I zwei, drei oder vier OH-Gruppen und sonst keine weiteren Substituenten. Die OH-Gruppen besetzen bevorzugt die 4,4′-, die 2,2′-, die 2,3,4- oder die

2,2',4,4'-Positionen. Bevorzugte Additive sind etwa die Verbindungen 2,3,4-Trihydroxybenzophenon, 4,4'-Dihydroxybiphenyl, 2,2'-Dihydroxybiphenyl, 4,4'-Dihydroxybenzophenon, Bis(4-hydroxyphenyl)ether, Bis(4-hydroxyphenyl)sulfid, Bis(2,4-dihydroxyphenyl)sulfid, Bis(4-hydroxyphenyl)sulfon, 2,2-Bis(4-hydroxyphenyl)propan. Besonders bevorzugt sind 2,3,4-Trihydroxybenzophenon, Bis(4-hydroxyphenyl)sulfon, 4,4'-Dihydroxybenzophenon und Bis(2,4-dihydroxyphenyl)sulfid und hiervon insbesondere 2,3,4-Trihydroxybenzophenon.

Die erfindungsgemäßen Positiv-Fotoresists enthalten typisch
50 bis 65 Gew.% alkalilösliches Harz,
18 bis 25 Gew.% 1,2-Naphthochinondiazid-5-sulfonyltrisester von 1,3,5-Trihydroxybenzol und
17 bis 25 Gew.% 2,3,4-Trihydroxybenzophenon,
jeweils bezogen auf den Gesamtfeststoffgehalt.

Als Lösungsmittel zur Herstellung der Fotoresist-Lösung sind im Prinzip alle Lösungsmittel geeignet, in denen die festen Fotoresist-Bestandteile wie alkalilösliches Harz, Chinondiazidverbindung, aromatische Hydroxyverbindung und gegebenenfalls weitere Zusatzstoffe ausreichend löslich sind und die mit diesen Bestandteilen nicht irreversibel reagieren. In Frage kommen hierfür beispielsweise aliphatische Ketone wie Methylethylketon, Cyclopentanon oder Cyclohexanon, aliphatische Ester wie Butylacetat, Ether wie Anisol oder Tetrahydrofuran, Alkohole wie n- oder i-Propanol, Mono- oder Bisether sowie gemischte Ether-Esterderivate von Glycolverbindungen wie von Ethylenglycol, Diethylenglycol oder Propylenglycol, des weiteren Monooxocarbonsäureester wie etwa Milchsäureethylester oder 2-Ethoxypropionsäureethylester, Lactone wie $\gamma$-Butyrolacton, cyclische Amide wie 2-Methylpyrrolidon. Aliphatische und aromatische Kohlenwasserstoffe wie n-Hexan und Xylol finden ebenfalls Verwendung als Lösungsmittel. Vielfach werden auch Gemische aus den genannten Lösungsmitteln verwendet. Verbreitet enthalten Fotoresis-Lösungsmittel Ethoxyethylacetat, Methoxypropylacetat oder Ethylenglycoldimethylether. Das Lösungsmittel hat üblicherweise einen Anteil von 40-90 Gew.% an der gesamten Fotoresist-Lösung.

Zu den weiteren üblichen Zusatzstoffen, die auch in den erfindungsgemäßen Fotoresists enthalten sein können, gehören etwa streustrahlungsabsorbierende Substanzen und Farbstoffe, Verlaufmittel, Weichmacher, Haftvermittler, weitere filmbildende Harze, Tenside und Stabilisatoren. Zusätze dieser Kategorien sind dem Fachmann ausreichend bekannt und sind vielfältig in der einschlägigen Fachliteratur beschrieben. Der Anteil an solchen Zusätzen übersteigt zusammengenommen kaum 25 Gew.%, bezogen auf den Gesamtfeststoffgehalt der Fotoresist-Lösung.

Die Formulierung der erfindungsgemäßen Positiv-Fotoresists erfolgt in an sich bekannter Weise durch Mischen bzw. Lösen der Komponenten in dem Lösungsmittel bzw. Lösungsmittelgemisch. Nach Lösung der Bestandteile im Lösungsmittel wird die erhaltene Fotoresist-Lösung je nach Anspruch an die Partikelfreiheit durch Membranfilter mit einer Porenweite von 0,1-1 µm filtriert. Üblicherweise wird der Gesamtfeststoffgehalt des Fotoresist auf die gewünschte Schichtdicke und Beschichtungsmethode abgestimmt.

Die Anwendung erfolgt nach an sich bekannten Verfahren und mit den hierfür üblichen Prozeßgeräten durch Beschichten eines Substrates mit der Fotoresistlösung, Trocknen der Schicht bei erhöhter Temperatur, bildmäßiges Belichten der Schicht mit Strahlung aus einem Wellenlängenbereich, in dem die Schicht empfindlich ist, und Entwickeln mit einem wäßrig-alkalischen Entwickler.

Als Substrate fungieren überwiegend Halbleiterscheiben, wie z.B. Silizium-Wafer, die gegebenenfalls mit einer Schicht aus Siliziumdioxid, Siliziumnitrid oder Aluminium überzogen sind. Auch andere bei der Herstellung miniaturisierter Schaltungen übliche Materialien wie Germanium, Galliumarsenid, Keramik mit gegebenenfalls Edelmetallbeschichtung kommen in Frage.

Die Beschichtung erfolgt üblicherweise durch Tauchen, Sprühen, Walzen oder Aufschleudern. Bei der letzteren, am häufigsten angewandten Beschichtungsmethode ist die resultierende Schichtdicke abhängig von der Viskosität der Fotoresist-Lösung, dem Feststoffgehalt und der Aufschleudergeschwindigkeit. Für den jeweiligen Fotoresist werden sogenannte Schleuderkurven ermittelt, aus denen sich die Resist-Schichtdicken in Abhängigkeit von Viskosität und Schleuderdrehzahl ermitteln lassen. Die Schichtdicken für Positiv-Fotoresists liegen typisch im Bereich von 0,5-4 µm, insbesondere 0,6-2,0 µm.

Nachdem der Fotoresist auf das Substrat aufgebracht worden ist, wird er normalerweise bei Temperaturen zwischen 70 °C und 130 °C vorgetrocknet. Dazu können Öfen oder Heizplatten (sogenannte "Hot Plates") verwendet werden. Die Trocknungszeit in Öfen liegt im Bereich von etwa 15-45 Minuten, auf Heizplatten im Bereich von etwa 0,5-4 Minuten. Vorzugsweise wird etwa 1 Minute bei etwa 100 °C auf der Heizplatte getrocknet.

Bevorzugt werden die erfindungsgemäßen Positiv-Fotoresists monochromatisch bei 436 nm belichtet, wobei ihre vorzügliche Auflösungseigenschaften besonders günstig in Erscheinung treten.

Die mit dem Fotoresist beschichteten und belichteten Substrate werden schließlich mit einer wäßrig-alkalischen Entwicklerlösung, z.B. durch Tauchen oder Besprühen, entwickelt, bis in den belichteten Bereichen der Resist voll ständig abgelöst ist. Es können verschiedene Entwicklerformulierungen verwendet werden, die entweder zur Klasse der metallionenhaltigen oder metallionenfreien Fotoresistentwickler gehören. Metallionenhaltige Entwickler sind wäßrige Lösungen von Natriumhydroxid oder Kaliumhydroxid, die daüber hinaus pH-regulierende und puffernde Substanzen, wie Phosphate oder Silikate sowie Tenside und Stabilisatoren enthalten können. Metallionenfreie Entwickler enthalten statt alkalischer Metallverbindungen organische Basen, wie z.B. Tetramethylammoniumhydroxyd oder Cholin. Die Entwicklungszeiten hängen von der Belichtungsenergie, Stärke des Entwicklers, Art des Entwickelns, der Vortrocknungstemperatur und der

Entwicklertemperatur ab. Bei der Tauchentwicklung sind Entwicklungszeiten von etwa 1 Minute typisch. Die Entwicklung wird üblicherweise durch Eintauchen oder Besprühen mit deionisiertem Wasser gestoppt. An die Entwicklung schließt sich häufig eine Nachtrocknung bei etwa 100 °C bis 180 °C an.

Die mit den erfindungsgemäßen Fotoresists hergestellten Reliefstrukturen zeigen eine vorzügliche Bildauflösung bis herab zu wenigstens 0,6 µm bei hohem Kontrast, hoher Kantensteilheit und Kantenschärfe. Der Schichtdickenverlust in den unbelichteten Bereichen ist minimal. In den nachfolgenden Prozeßabläufen bei der Herstellung von integrierten Halbleiterschaltungen wie Ätzen mit Säure oder im Plasma, Dotieren oder Beschichten, zeigen sie hervorragende Eigenschaften und gewährleisten einen wirksamen Schutz der mit den Fotoresist-Reliefstrukturen abgedeckten Bereiche des Schichtträgers.

## Beispiele

A. Fotoresist-Formulierungen

Sofern nicht anders angegeben, wurden Fotoresist-Formulierungen aus den Komponenten

(a) m-Kresol-Novolak-Harz mit mittlerer Molmasse $\overline{Mw}$ = 9000

(b) 1,2-Naphthochinondiazid-5-sulfonyltrisester von 1,3,5-Trihydroxybenzol

(c) 2,3,4-Trihydroxybenzophenon in den unter C. angegebenen Prozentanteilen, bezogen auf den Gesamtfeststoffgehalt, in Form 35%iger Lösungen in Diethylenglycoldimethylether hergestellt und diese durch Filter mit 0,2 µm Porenweite filtriert.

B. Versuchsmethodik

Die Fotoresist-Formulierungen wurden auf oberflächlich oxidierte Silizium-Scheiben von 4" Durchmesser aufgeschleudert, wobei die Schleuderdrehzahl so gewählt wurde, daß nach dem Trocknen auf der Heizplatte für 1 Minute bei 100 °C eine Schichtdicke von jeweils 1,5 µm resultierte.

Danach wurde durch eine Auflösungstestmaske monochromatisch bei 436 nm mit einer Optik der numerischen Apertur NA = 0,35 belichtet und anschließend durch Eintauchen in 1,62%ige wäßrige Tetramethylammoniumhydroxid-Lösung bei 20 °C für 60 Sekunden entwickelt.

Die Inspektion der erhaltenen Resiststrukturen erfolgte unter dem Rasterelektronenmikroskop hinsichtlich Auflösung und Kantenschärfe.

C. Ergebnis

Die nachfolgende Tabelle zeigt für erfindungsgemäße Fotoresist-Formulierungen (Beispiele 1 und 2) sowie Vergleichsformulierungen (Beispiele 3 bis 6) bei unterschiedlichen Prozentanteilen der Komponenten (a), (b) und (c) die sich ergebenden Absorptionskoeffizienten für die fotobleichbare Absorption (A-Wert) und die maximale Bildauflösung mit der Charakterisierung der Kantenprofile.

| Beispiel | Komponenten (Gew.%) | | | A-Wert | Auflösung/Kantenprofil |
|---|---|---|---|---|---|
| | (a) | (b) | (c) | | |
| 1 | 60,0 | 18,0 | 22,0 | 0,54 | 0,6 µm/senkrechte Kanten |
| 2 | 62,4 | 18,6 | 19,0 | 0,56 | 0,6 µm/senkrechte Kanten |
| 3 | 72,0 | 10,0 | 18,0 | 0,30 | 0,8 µm/keine senkrechten Kanten; nicht maßhaltig |
| 4 | 70,2 | 14,4 | 15,4 | 0,41 | 0,9 µm/keine senkrechten Kanten |
| 5 | 67,0 | 21,0 | 12,0 | 0,65 | 0,9 µm/senkrechte Kanten |
| 6 | 68,0 | 20,4* | 11,6 | 0,65 | 0,9 µm/keine senkrechten Kanten |

* Veresterungsprodukt von 1 Mol 2,3,4,4'-Tetrahydroxybenzophenon mit 3 Mol 1,2-Naphthochinondiazid-5-sulfonylchlorid.

Es zeigt sich, daß sich nur mit den erfindungsgemäßen Positiv-Fotoresist-Formulierungen bis 0,6 µm

aufgelöste Strukturen mit senkrechtem und scharfem Kantenprofil erhalten lassen.

**Patentansprüche**

1. Positiv-Fotoresists, enthaltend in einem organischen Lösungsmittel im wesentlichen mindestens je
(a) ein alkalilösliches Harz
(b) einen 1,2-Naphthochinondiazid-5-sulfonylester eines Trihydroxybenzol-Isomeren
(c) eine aromatische Hydroxyverbindung
sowie gegebenenfalls weitere übliche Zusatzstoffe, dadurch gekennzeichnet, daß durch Komponente (b) für die fotobleichbare Absorption ein Absorptionskoeffizient von mindestens 0,5 $\mu m^{-1}$ resultiert und Komponente (c) in einer Konzentration von 15-30 Gew.%, bezogen auf den Gesamtfeststoffgehalt, enthalten ist.

2. Positiv-Fotoresists nach Anspruch 1, dadurch gekennzeichnet, daß als Komponente (b) der 1,2-Naphthochinondiazid-5-sulfonyltrisester von 1,3,5-Trihydroxybenzol enthalten ist.

3. Positiv-Fotoresists nach Anspruch 2, dadurch gekennzeichnet, daß Komponente (b) in einer Konzentration von 17 bis 30 Gew. %, bezogen auf den Gesamtfeststoffgehalt, enthalten ist.

4. Positiv-Fotoresists nach mindestens einem der Ansprüche 1 bis 3, dadurch gekennzeichnet, daß als Komponente (c) eine Verbindung der Formel I

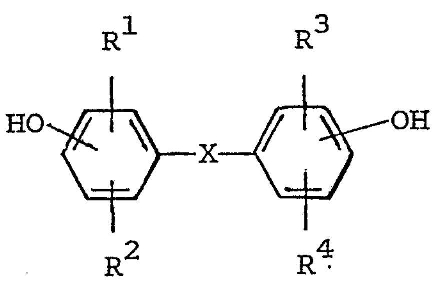

(I)

enthalten ist, worin
X eine Einfachbindung, -0-, -S-, $SO_2$, CO oder $CR_5R_6$,
$R^1$, $R^2$, $R^3$, $R^4$ jeweils H, Halogen, $C_{1-4}$-Alkyl, $C_{1-4}$-Alkoxy oder OH,
$R^5$, $R^6$ jeweils H, $C_{1-4}$-Alkyl oder $C_{1-14}$-Perfluoralkyl
bedeuten, enthalten ist.

5. Positiv-Fotoresists nach Anspruch 4, dadurch gekennzeichnet, daß als Komponente (c) eine Verbindung aus der Gruppe
2,3,4-Trihydroxybenzophenon
4,4′-Dihydroxybenzophenon
4,4′-Dihydroxybiphenyl
2,2′-Dihydroxybiphenyl
Bis(4-hydroxyphenyl)ether
Bis(4-hydroxyphenyl)sulfid
Bis(2,4)-dihydroxyphenyl)sulfid
Bis(4-hydroxyphenyl)sulfon
2,2-Bis-(4-hydroxyphenyl)propan
enthalten ist.

6. Positiv-Fotoresists nach Anspruch 4, dadurch gekennzeichnet, daß als Komponente (c) 2,3,4-Trihydroxybenzophenon enthalten ist.

7. Positiv-Fotoresists nach Anspruch 1, dadurch gekennzeichnet, daß
(a) 50 bis 65 Gew.% alkalilösliches Harz,
(b) 18 bis 25 Gew.% 1,2-Naphthochinondiazid-5-sulfonyltrisester von 1,3,5-Trihydroxybenzol und
(c) 17 bis 25 Gew.% 2,3,4-Trihydroxybenzophenon,
jeweils bezogen auf den Gesamtfeststoffgehalt, enthalten sind.

8. Verwendung von Positiv-Fotoresists nach den Ansprüchen 1 bis 7 als im nahen UV hochauflösende Fotoresists.

9. Verfahren zur Herstellung von Fotoresistreliefstrukturen mit einer Auflösung bis herab zu wenigstens 0,6 µm durch Beschichten eines Halbleitersubstrates mit einem Positiv-Fotoresist, bildmäßiges Belichten mit Strahlung aus dem nahen UV-Wellenlängenbereich, Entwickeln mit einem wäßrig-alkalischen Entwickler, dadurch gekennzeichnet, daß ein Positiv-Fotoresist nach einem der Ansprüche 1 bis 7 verwendet wird.